# EUROPEAN PATENT APPLICATION

(11) **EP 4 773 786 A1**
(43) Date of publication of application: **08.07.2026**
(21) Application number: 24885273.3
(22) Date of filing: 29.08.2024
(51) Int. Cl.: H10N 30/853, C23C 14/34, H03H 9/17, H10N 30/076, H10N 30/079

(54) **NITRIDE MATERIAL, PIEZOELECTRIC BODY COMPOSED OF SAME, MEMS DEVICE USING PIEZOELECTRIC BODY THEREOF, NITRIDE MATERIAL THEREOF, FERROELECTRIC BODY COMPOSED OF SAME, AND ELECTRONIC ELEMENT USING FERROELECTRIC BODY THEREOF**

(30) Priority: 02.11.2023 JP 2023188952
(71) Applicant: National Institute of Advanced Industrial Science and Technology, Chiyoda-ku Tokyo 100-8921 (JP)
(72) Inventor: UEHARA Masato, Tsukuba-shi, Ibaraki 305-8560 (JP); AKIYAMA Morito, Tsukuba-shi, Ibaraki 305-8560 (JP); HIRATA Kenji, Tsukuba-shi, Ibaraki 305-8560 (JP); TABARU Tatsuo, Tsukuba-shi, Ibaraki 305-8560 (JP); YAMADA Hiroshi, Tsukuba-shi, Ibaraki 305-8560 (JP); Anggraini Sri Ayu, Tsukuba-shi, Ibaraki 305-8560 (JP)
(74) Representative: Groth, Wieland
(86) International application number: PCT/JP2024/030958
(87) International publication number: WO 2025/094496

(57) **Abstract**

[Object] To provide scandium-doped gallium nitride having a piezoelectric constant d₃₃ exceeding 14 pC/N, scandium-doped gallium nitride having a piezoelectric constant d₃₃ exceeding 16.9 pC/N, in particular a scandium-doped gallium nitride material having a higher piezoelectric constant d₃₃ than the maximum piezoelectric constant d₃₃ value (27.6 pC/N) of scandium-doped aluminum nitride, a piezoelectric body composed of the same, a MEMS device using the piezoelectric body, a nitride material thereof, a ferroelectric body composed of the same, an electronic device using the ferroelectric body, and a method for producing the scandium-doped gallium nitride.

[Solution] A nitride material expressed by a chemical formula ScₓGa₁₋ₓN, in which x is within a range of 0.39 or more and 0.54 or less, and a length of a c-axis in a crystal structure is within a range of 4.94×10⁻¹⁰ m or more and less than 5.2×10⁻¹⁰ m.

## Description

### Technical Field

The present invention relates to a scandium-doped gallium nitride material, a piezoelectric body composed of the same, a MEMS device using the piezoelectric body, a gallium nitride material thereof, a ferroelectric body composed of the same, and an electronic device using the ferroelectric body.

### Background Art

Devices utilizing the piezoelectric phenomenon are employed across a wide range of fields, and their use is expanding in portable devices such as mobile phones, where miniaturization and reduction in power consumption are strongly demanded. One example thereof is an FBAR filter, which uses a film bulk acoustic resonator (FBAR).

FBAR filters are filters using a resonator which utilizes a thickness-longitudinal vibration mode of a thin film exhibiting piezoelectric response, and have a characteristic of being able to resonate in a gigahertz band. FBAR filters with such a characteristic are low-loss and can operate over a wide band, and are therefore expected to contribute to higher frequency operation, further miniaturization, and further reduction in power consumption of portable devices.

As piezoelectric materials for piezoelectric thin films used in such FBARs, examples include scandium-doped aluminum nitride (see Patent Literature 1) and scandium-doped gallium nitride (Patent Literature 2). In particular, scandium-doped aluminum nitride has a high piezoelectric constant (d₃₃) and is utilized as a high-frequency filter for fifth-generation mobile communication systems (5G). Further, scandium-doped aluminum nitride is expected to be used in various micro electro mechanical system (MEMS) devices such as physical sensors including pressure sensors, acceleration sensors, gyro sensors, and so forth, actuators, microphones, speakers, ultrasonic oscillators, ultrasonic sensors, fingerprint authentication sensors, and vibration generators.

### Citation List

### Patent Literature

Patent Literature 1: Japanese Unexamined Patent Application Publication No. 2009-10926
Patent Literature 2: Japanese Patent No. 6698159

### Non-Patent Literature

Non-Patent Literature 1: Uehara et al., Applied Physics letters 114,012902, 2019.
Non-Patent Literature 2: Tholander al., Physical Review B 87,094107 2013.
Non-Patent Literature 3: Akiyama et al., Applied Physics letters 95,162107, 2009.

### Summary of Invention

### Technical Problem

However, the maximum piezoelectric constant d₃₃ of scandium-doped gallium nitride (ScₓGa₁₋ₓN) is 14 pC/N (see Non-Patent Literature 1), and there has been a problem in that no ScₓGa₁₋ₓN with a piezoelectric constant d₃₃ exceeding this value exist. In addition, the maximum piezoelectric constant d₃₃ of ScₓGa₁₋ₓN determined by first-principles calculations is 16.9 pC/N (see Non-Patent Literature 2).

Therefore, there has been a problem in that ScₓGa₁₋ₓN naturally does not exist which exceeds the maximum piezoelectric constant d₃₃ (27.6 pC/N) of the above-mentioned scandium-doped aluminum nitride (ScₓAl₁₋ₓN) (see Non-Patent Literature 3).

In view of the circumstances described above, the present invention aims to provide scandium-doped gallium nitride having a piezoelectric constant d₃₃ exceeding 14 pC/N, scandium-doped gallium nitride having a piezoelectric constant d₃₃ exceeding 16.9 pC/N, in particular a scandium-doped gallium nitride material having a higher piezoelectric constant d₃₃ than the maximum piezoelectric constant d₃₃ value (27.6 pC/N) of scandium-doped aluminum nitride, a piezoelectric body composed of the same, a MEMS device using the piezoelectric body, a gallium nitride material thereof, a ferroelectric body composed of the same, an electronic device using the ferroelectric body, and a method for producing the scandium-doped gallium nitride.

### Solution to Problem

As a result of intensive research into the above-mentioned problems, the inventors of the present invention have found that gallium nitride doped with scandium (Sc) within a predetermined concentration range (ScₓGa₁₋ₓN) and having a length of a c-axis (c-axis in a crystal structure) within a predetermined range has a piezoelectric constant d₃₃ which is higher than the above-mentioned maximum piezoelectric constant d₃₃ (14 pC/N) of the conventional ScₓGa₁₋ₓN, is higher than the above-mentioned maximum piezoelectric constant d₃₃ (16.9 pC/N) of ScₓGa₁₋ₓN determined by first-principles calculations, and also is higher than the maximum piezoelectric constant d₃₃ (27.6 pC/N) of scandium-doped aluminum nitride, and has high ferroelectricity, and have invented the following innovative nitride material.

The contents of Japanese Patent Application No. 2023-188952 are incorporated herein by reference as forming part of this specification.

A first aspect of the present invention to solve the above-described problems is a nitride material expressed by a chemical formula ScₓGa₁₋ₓN, in which x is within a range of 0.39 or more and 0.54 or less, and a length of a c-axis in a crystal structure is within a range of 4.94×10⁻¹⁰ m or more and 5.2×10⁻¹⁰ m or less.

Here, the "c-axis" refers to the axis which forms an angle of 90 degrees with the other two axes among the three axes in a hexagonal crystal such as a wurtzite crystal.

According to the first aspect, scandium-doped gallium nitride having a piezoelectric constant d₃₃ exceeding 16.9 pC/N can be provided.

A second aspect of the present invention is the nitride material according to the first aspect, in which the x is within a range of 0.45 or more and 0.54 or less.

According to the second aspect, scandium-doped gallium nitride having a higher maximum piezoelectric constant d₃₃ can be provided.

A third aspect of the present invention is the nitride material according to the first aspect, in which the x is within a range of 0.5 or more and 0.54 or less.

According to the third aspect, scandium-doped gallium nitride having a high maximum piezoelectric constant d₃₃ can be provided.

A fourth aspect of the present invention is the nitride material according to the first aspect, in which the length of the c-axis is within a range of 4.94×10⁻¹⁰ m or more and 5.05×10⁻¹⁰ m or less.

According to the fourth aspect, scandium-doped gallium nitride having a higher maximum piezoelectric constant d₃₃ can be provided.

A fifth aspect of the present invention is the nitride material according to the first aspect, in which a length of an a-axis in the crystal structure is within a range of 3.4×10⁻¹⁰ m or more and 3.5×10⁻¹⁰ m or less.

Here, the "a-axis" refers to two axes which form an angle of 90 degrees with the above-mentioned c-axis, and lattice constants of these are identical.

According to the fifth aspect, scandium-doped gallium nitride having a higher piezoelectric constant d₃₃ can be provided.

A sixth aspect of the present invention is the nitride material according to the first aspect, in which the length of the a-axis is within a range of 3.44×10⁻¹⁰ m or more and 3.48×10⁻¹⁰ m or less.

According to the sixth aspect, scandium-doped gallium nitride having a still higher maximum piezoelectric constant d₃₃ can be provided.

A seventh aspect of the present invention is the nitride material according to the first aspect, in which a thickness is within a range from 1 nm to 3000 nm.

According to the seventh aspect, scandium-doped gallium nitride having a high piezoelectric constant d₃₃ can be provided.

An eighth aspect of the present invention is a piezoelectric body composed of the nitride material according to any one of the first to seventh aspects.

According to the eighth aspect, a piezoelectric body having a high piezoelectric constant d₃₃ can be provided.

A ninth aspect of the present invention is a piezoelectric body in which the nitride material according to any one of the first to seventh aspects is provided on a substrate, and at least one intermediate layer is provided between the nitride material and the substrate.

According to the ninth aspect, the crystallinity (degree of crystallinity) of the piezoelectric body is improved and accordingly, a piezoelectric body having higher piezoelectricity can be provided.

A tenth aspect of the present invention is the piezoelectric body according to the ninth aspect, in which a diffusion layer containing a material constituting the intermediate layer and a material constituting the piezoelectric body is further provided between the intermediate layer and the piezoelectric body.

According to the tenth aspect, as with the ninth aspect, a piezoelectric body having high piezoelectricity can be provided.

An eleventh aspect of the present invention is a MEMS device using the piezoelectric body according to the eighth aspect.

Here, the "MEMS device" is not particularly limited as long as it is a microelectromechanical system, and examples thereof include high-frequency filters such as FBAR filters and solidly mounted resonators (SMR), physical sensors such as vibrators, pressure sensors, acceleration sensors, and gyro sensors, actuators, microphones, speakers, ultrasonic oscillators, ultrasonic sensors, fingerprint authentication sensors, vibration generators, and energy harvesters.

According to the eleventh aspect, a MEMS device configured to enable higher frequency operation, miniaturization, and reduced power consumption can be provided. In particular, when the MEMS device is a high-frequency filter, it is possible to provide the one which is low-loss and can operate over a wide band compared to conventional high-frequency filters.

A twelfth aspect of the present invention is a ferroelectric body composed of the nitride material according to any one of the first to seventh aspects.

According to the twelfth aspect, a ferroelectric body exhibiting high ferroelectricity can be provided.

A thirteenth aspect of the present invention is an electronic device using the ferroelectric body according to the twelfth aspect.

Here, the "electronic device" includes devices such as ferroelectric nonvolatile memories (including field-effect ferroelectric nonvolatile memories), resistance-variable nonvolatile memories, piezo-resistive transistors, energy storage devices, piezoelectric devices (piezoelectric elements), pyroelectric devices, piezoelectric sensors, and electrocaloric effect devices.

According to the thirteenth aspect, due to its high ferroelectricity, a small-sized and high-performance electronic device can be provided.

A fourteenth aspect of the present invention is a nitride material production method for producing the nitride material according to any one of the first to seventh aspects by using sputtering, in which nitrogen is included as a sputtering gas. A target composed of scandium and a target composed of gallium nitride, a target composed of scandium and a target composed of an alloy containing scandium and gallium, a target composed of gallium nitride and a target composed of an alloy containing scandium and gallium, or a target composed of an alloy containing scandium and gallium are used as a sputtering target.

According to the fourteenth aspect, a piezoelectric body having a high piezoelectric constant d₃₃ can be produced.

A fifteenth aspect of the present invention is the nitride material production method according to the fourteenth aspect, in which a heating temperature of a substrate, on which the nitride material is to be formed, during film deposition is within a range of 25°C or higher and lower than 400°C.

According to the fifteenth aspect, a piezoelectric body having a higher piezoelectric constant d₃₃ can be produced.

### Brief Description of Drawings

[Fig. 1] Fig. 1 is a schematic sectional view of a piezoelectric thin film according to Embodiment 1.
[Fig. 2] Fig. 2 is a table showing conditions for depositing each piezoelectric thin film in Example 1 and data of each piezoelectric film.
[Fig. 3] Fig. 3 is a graph showing a relationship between substrate heating temperature and piezoelectric constant d₃₃ during film deposition of each piezoelectric thin film in Example 1.
[Fig. 4] Fig. 4 is a table showing data of each piezoelectric thin film in Example 2.
[Fig. 5] Fig. 5 is a table showing data of each piezoelectric thin film in Example 3.
[Fig. 6] Fig. 6 is a table showing conditions for depositing each piezoelectric thin film in Example 4 and data of each piezoelectric film.
[Fig. 7] Fig. 7 is a table showing conditions for depositing each piezoelectric thin film in Example 5 and data of each piezoelectric film.
[Fig. 8] Fig. 8 is a table showing conditions for depositing each piezoelectric thin film in Example 6 and data of each piezoelectric film.
[Fig. 9] Fig. 9 is a graph showing a relationship between concentration of Sc and the piezoelectric constant d₃₃ for respective piezoelectric thin films in Examples 1 to 6.
[Fig. 10] Fig. 10 is a graph showing a relationship between length of a c-axis and piezoelectric constant d₃₃ for respective piezoelectric thin films in Examples 1 to 6.
[Fig. 11] Fig. 11 is a graph showing a relationship between length of an a-axis and piezoelectric constant d₃₃ for respective piezoelectric thin films in Examples 1 to 6.
[Fig. 12] Fig. 12 is a schematic sectional view of a piezoelectric thin film according to Embodiment 2.
[Fig. 13] Fig. 13 is a table showing data of each ferroelectric thin film in Example 7.
[Fig. 14] Fig. 14 is a graph showing a hysteresis loop of a ferroelectric thin film No. 3 in Example 7.

### Description of Embodiments

Embodiments of a nitride material according to the present invention will be described below with reference to the accompanying drawings. However, note that the present invention is not limited to the following embodiments.

### (Embodiment 1)

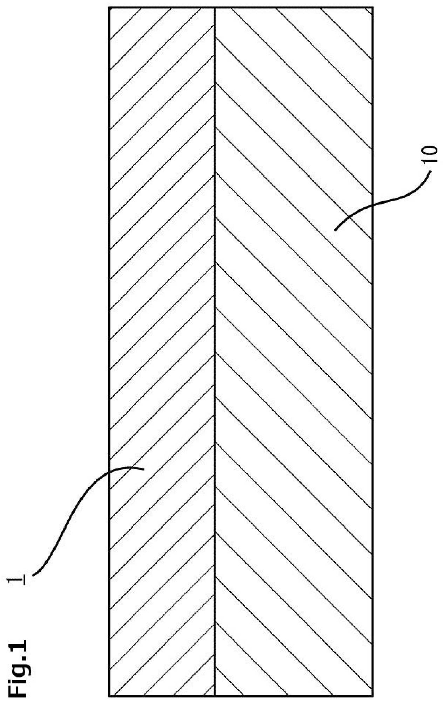

Fig. 1 is a schematic lateral view of a piezoelectric thin film composed of a nitride material according to the present embodiment. As illustrated in this drawing, a piezoelectric thin film 1 is formed on a substrate 10.

The substrate 10 is not particularly limited in thickness, material, and so forth as long as the piezoelectric thin film 1 can be formed on the surface thereof. Examples of the substrate 10 include silicon, heat-resistant alloys such as inconel, and resin films such as polyimide.

The piezoelectric thin film 1 is composed of a nitride material characterized to be expressed by the chemical formula ScₓGa₁₋ₓN, where x is within the range of 0.39 or more and 0.54 or less and the length of the c-axis in the crystal structure is within the range of 4.94× 10⁻¹⁰ m or more and 5.2×10⁻¹⁰ m or less.

Such a piezoelectric thin film 1 has a maximum piezoelectric constant d₃₃ which is at least higher than the maximum piezoelectric constant d₃₃ value (14 pC/N) of conventional ScₓGa₁₋ₓN and is higher than the maximum piezoelectric constant d₃₃ (16.9 pC/N) of ScₓGa₁₋ₓN determined by first-principles calculations.

Here, as the piezoelectric thin film 1, one in which x in the above chemical formula is within the range of 0.45 or more and 0.54 or less is preferable because it has a higher maximum piezoelectric constant d₃₃, and one in which x is within the range of 0.5 or more and 0.54 or less is also preferable because it has a high maximum piezoelectric constant d₃₃.

Further, the piezoelectric thin film 1 having the length of the c-axis within the range of 4.94×10⁻¹⁰ m or more and 5.05×10⁻¹⁰ m or less in these crystal structures is particularly preferable because it has a piezoelectric constant d₃₃ value higher than the maximum piezoelectric constant d₃₃ (27.6 pC/N) of SeₓAl₁₋ₓN.

Moreover, the piezoelectric thin film 1 having the length of an a-axis within the range of 3.40×10⁻¹⁰ m or more and 3.5×10⁻¹⁰ m or less in these crystal structures is more preferable because it has a higher value of the piezoelectric constant d₃₃, and the piezoelectric thin film 1 having the length of the a-axis within the range of 3.44× 10⁻¹⁰ m or more and 3.48×10⁻¹⁰ m or less is particularly preferable because it has a still higher value of the piezoelectric constant d₃₃.

The thickness of the piezoelectric thin film 1 (film thickness) is not particularly limited, but is preferably 1 nm to 3000 nm, more preferably 10 nm to 1000 nm, and particularly preferably 100 nm to 1000 nm.

Furthermore, the piezoelectric thin film 1 may contain a rare gas such as argon (Ar) and neon (Ne), and it is particularly preferable that the piezoelectric thin film 1 contains Ar. Examples of the piezoelectric thin film 1 containing Ar include nitride materials expressed by the chemical formula (ScₓGa₁₋ₓ)_{1-y}Ar_{y}N, where x is within the range of 0.39 or more and 0.54 or less and y is within the range of 0.0016 or more and 0.006 or less, where x is within the range of 0.45 or more and 0.54 or less and y is within the range of 0.0016 or more and 0.006 or less, and where x is within the range of 0.5 or more and 0.54 or less and y is within the range of 0.0016 or more and 0.006 or less. Piezoelectric thin films composed of such nitride materials containing Ar have high piezoelectric constants d₃₃, similar to the above-mentioned piezoelectric thin film.

Further, high-frequency filters using these piezoelectric thin films 1 are low-loss and can operate over a wide band compared to high-frequency filters composed of SeₓAl₁₋ₓN. This enables portable devices to achieve higher frequency operation, miniaturization, and reduced power consumption thereof. The configurations of the high-frequency filters are not particularly limited, and they can be produced with known configurations.

A method for producing the piezoelectric thin film 1 according to the present embodiment will now be described. The piezoelectric thin film 1 can be produced using a producing method such as sputtering or vapor deposition, similar to general piezoelectric thin films. Specifically, for example, it can be produced by simultaneously sputtering two targets onto the substrate 10 (for example, a silicon (Si) substrate) under a nitrogen gas (N₂) atmosphere or under a mixed atmosphere of nitrogen gas (N₂) and argon gas (Ar). The combination of these two targets includes: a target composed of scandium and a target composed of gallium nitride (GaN); a target composed of scandium and a target composed of an alloy containing scandium and gallium; or a target composed of gallium nitride and a target composed of an alloy containing scandium and gallium.

Here, only a target composed of an alloy containing scandium and gallium (a target composed of an alloy containing scandium and gallium alone) may be used as the sputtering target. The alloy containing scandium and gallium is not particularly limited as long as the Sc ratio to the total amount of Sc and Ga in the sputtering target is 25 atomic % or more and less than 100 atomic %. Specific examples of the alloy containing scandium and gallium include one or a plurality of intermetallic compounds selected from the group consisting of Ga₃Sc, Ga₂Sc, Ga₃Sc₂, GaSc, Ga₄Sc₅, and Ga₃Sc₅.

Further, the sputtering gas may contain a rare gas other than Ar. By using a sputtering gas containing a rare gas such as Ar, ScₓGa₁₋ₓN having a high piezoelectric constant d₃₃ can be easily produced. The rare gas may be a single gas such as Ar, or a mixed gas of a plurality of types of rare gases such as a mixed gas of Ar and Kr. Among these rare gases, Ar alone is particularly preferable. The inclusion of Ar in the sputtering gas further facilitates the production of the piezoelectric thin film composed of the nitride material according to the present invention.

The concentration of the rare gas contained in the sputtering gas is not particularly limited, but is preferably within a range of 5 mol% or more and 95 mol% or less, more preferably within a range of 20 mol% or more and 95 mol% or less, and particularly preferably within a range of 50 mol% or more and 90 mol% or less.

Furthermore, the temperature of the substrate, on which the piezoelectric thin film 1 is to be formed, during deposition (substrate heating temperature) is preferably within a range of room temperature (25°C) or higher and lower than 400°C as this facilitates the production of the piezoelectric thin film 1; more preferably within the range of 100°C to 350°C as this further facilitates the production of the piezoelectric thin film 1; and particularly preferably within the range of 150°C to 300°C as this still further facilitates the production of the piezoelectric thin film 1.

In addition, the pressure of the sputtering gas is not particularly limited, but is preferably 1 Pa or less, more preferably within the range of 0.1 Pa to 0.7 Pa, and particularly preferably within the range of 0.2 Pa to 0.5 Pa.

### <Example 1>

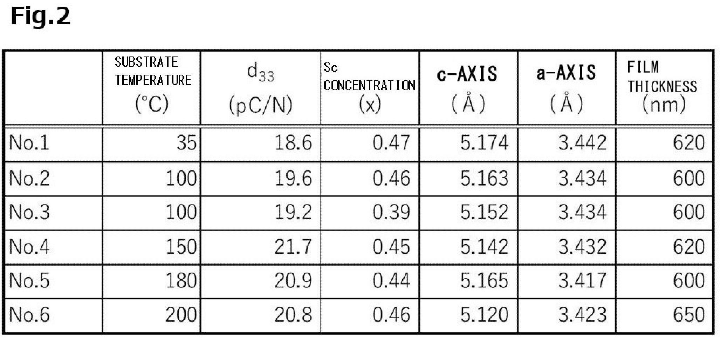

Using the following apparatus and sputtering targets, piezoelectric thin films composed of scandium-doped gallium nitride (ScₓGa₁₋ₓN), shown in Fig. 2, were produced on conductive silicon substrates (0.02 Ω·cm or less) on which a Hf intermediate layer (thickness 100 nm to 130 nm) had been formed in advance.

Sputtering deposition apparatus (manufactured by ULVAC, Inc.)
Sc sputtering target material (purity: 99.99%)
GaN powder sintered sputtering target material (purity: 99.99%)
Gas: Mixed gas of nitrogen (purity: 99.99995% or higher) and argon gas (purity: 99.9999% or higher) (mixing ratio (nitrogen:argon) 30:70)
Sputtering gas pressure: 0.25 Pa
Substrate heating temperature: 35°C to 200°C

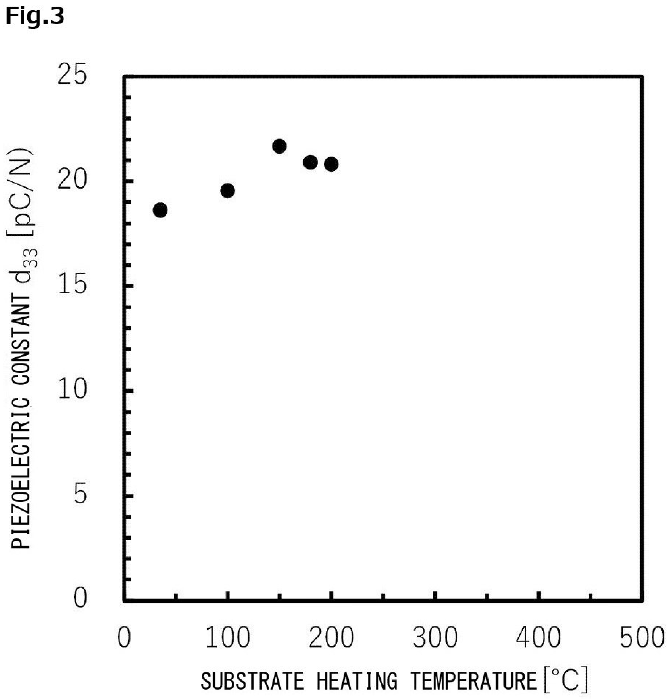

Fig. 3 shows a graph illustrating the relationship between the substrate heating temperature and the piezoelectric constant d₃₃ during film deposition of each of the obtained piezoelectric thin films. As can be seen from this drawing, it was found that each piezoelectric film according to Example 1 (deposited at the substrate heating temperature of 35°C to 200°C) has a higher piezoelectric constant d₃₃ than the maximum piezoelectric constant d₃₃ (16.9 pC/N) of ScₓGa₁₋ₓN determined by first-principles calculations. The piezoelectric constant d₃₃ was evaluated using a piezometer (PM300 (manufactured by Alpha Corporation LLC)) after depositing Al with a diameter of 2.5 mm as an upper electrode by vapor deposition.

### <Example 2>

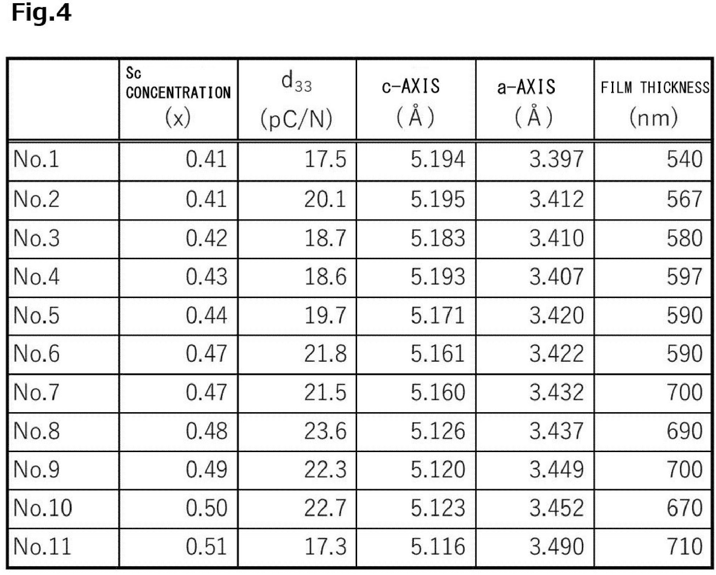

Using the following apparatus and sputtering targets, piezoelectric thin films composed of scandium-doped gallium nitride (ScₓGa₁₋ₓN), shown in Fig. 4, were deposited directly on conductive silicon substrates (0.02 Ω·cm or less).

Sputtering deposition apparatus (manufactured by ULVAC, Inc.)
Sc sputtering target material (purity: 99.99%)
GaN powder sintered sputtering target material (purity: 99.99%)
Gas: Mixed gas of nitrogen (purity: 99.99995% or higher) and argon gas (purity: 99.9999% or higher) (mixing ratio (nitrogen:argon) 30:70)
Sputtering gas pressure: 0.25 Pa
Substrate heating temperature: 150°C

### <Example 3>

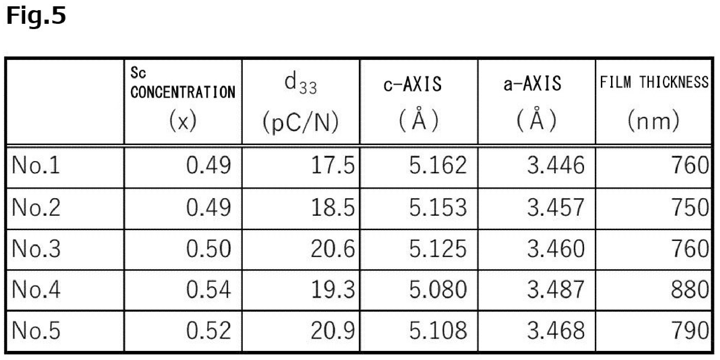

Using the following apparatus and sputtering targets, piezoelectric thin films composed of scandium-doped gallium nitride (ScₓGa₁₋ₓN), shown in Fig. 5, were deposited directly on conductive silicon substrates (0.02 Ω·cm or less).
Sputtering deposition apparatus (manufactured by ULVAC, Inc.)
Sc-Ga alloy sputtering target material (Sc:Ga = 50:50, purity: 99.99%)
Sc metal sputtering target material (purity: 99.99%)
Gas: Mixed gas of nitrogen (purity: 99.99995% or higher) and argon gas (purity: 99.9999% or higher) (mixing ratio (nitrogen:argon) 30:70)
Sputtering gas pressure: 0.25 Pa
Substrate heating temperature: 200°C

### <Example 4>

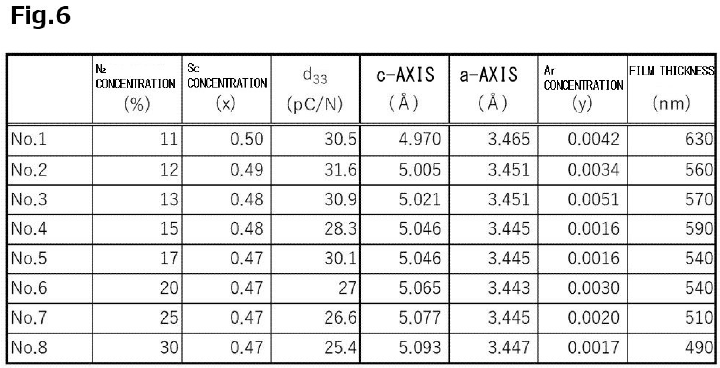

Using the following apparatus and sputtering targets, piezoelectric thin films composed of scandium-doped gallium nitride (ScₓGa₁₋ₓN), shown in Fig. 6, were deposited directly on conductive silicon substrates (0.02 Ω·cm or less).

Sputtering deposition apparatus (manufactured by ULVAC, Inc.)
Sc sputtering target material (purity: 99.99%)
GaN powder sintered sputtering target material (purity: 99.99%)
Gas: Mixed gas of nitrogen (purity: 99.99995% or higher) and argon gas (purity: 99.9999% or higher) (mixing ratio (nitrogen:argon) 10:90 to 30:70)
Sputtering gas pressure: 0.45 Pa
Substrate heating temperature: 200°C

### <Example 5>

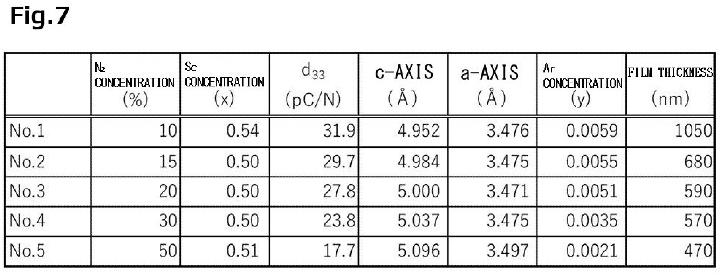

Using the following apparatus and sputtering targets, piezoelectric thin films composed of scandium-doped gallium nitride (ScₓGa₁₋ₓN), shown in Fig. 7, were deposited directly on conductive silicon substrates (0.02 Ω·cm or less).

Sputtering deposition apparatus (manufactured by ULVAC, Inc.)
Sc-Ga alloy sputtering target material (Sc:Ga = 50:50, purity: 99.9%)
Sc metal sputtering target material (purity: 99.99%)
Gas: Mixed gas of nitrogen (purity: 99.99995% or higher) and argon gas (purity: 99.9999% or higher) (mixing ratio (nitrogen:argon) 10:90 to 50:50)
Sputtering gas pressure: 0.45 Pa
Substrate heating temperature: 200°C

### <Example 6>

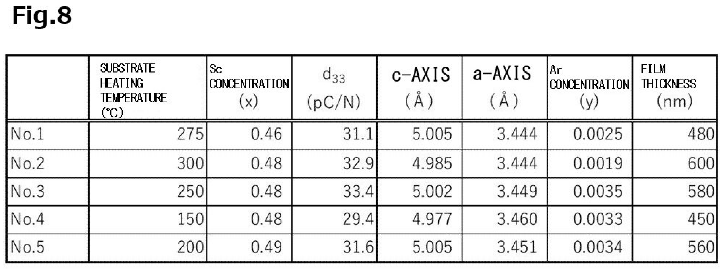

Using the following apparatus and sputtering targets, piezoelectric thin films composed of scandium-doped gallium nitride (ScₓGa₁₋ₓN), shown in Fig. 8, were deposited directly on conductive silicon substrates (0.02 Ω·cm or less).

Sputtering deposition apparatus (manufactured by ULVAC, Inc.)
Sc sputtering target material (purity: 99.99%)
GaN powder sintered sputtering target material (purity: 99.99%)
Gas: Mixed gas of nitrogen (purity: 99.99995% or higher) and argon gas (purity: 99.9999% or higher) (mixing ratio (nitrogen:argon) 12:88)
Sputtering gas pressure: 0.45 Pa
Substrate heating temperature: 150°C to 300°C

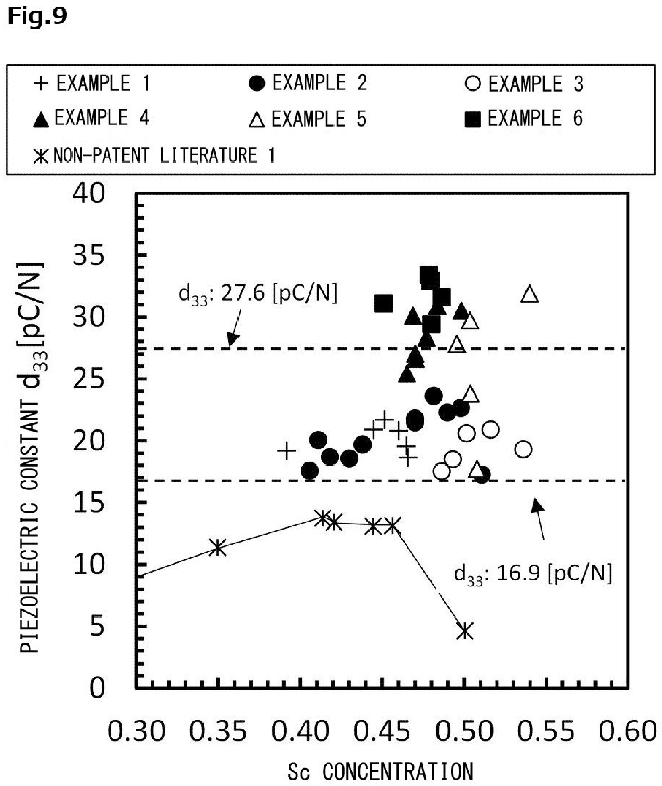

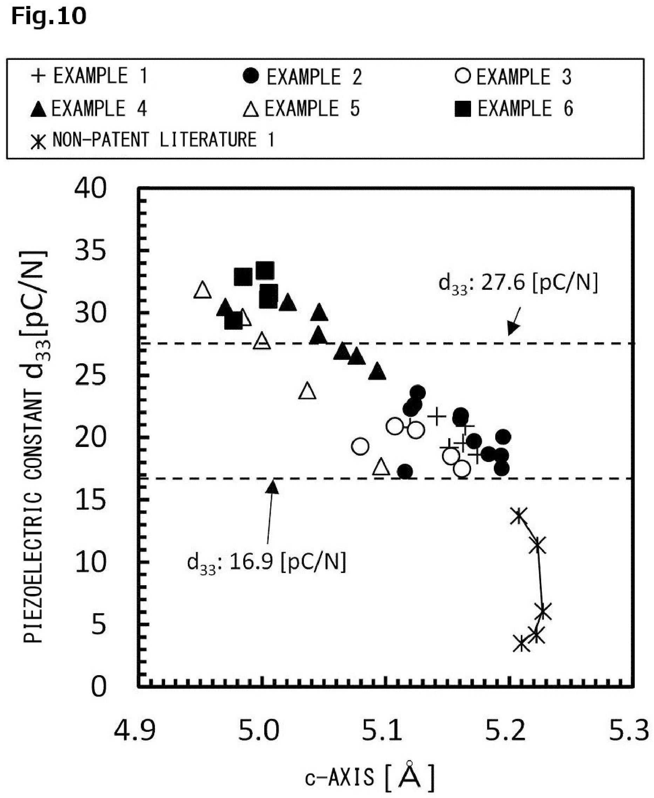

Next, for each of the piezoelectric thin films of Examples 1 to 6, Fig. 9 shows a graph illustrating the relationship between the concentration of Sc and the piezoelectric constant d₃₃, while Fig. 10 shows a graph illustrating the relationship between the length of the c-axis and the piezoelectric constant d₃₃. Here, the data for Non-Patent Literature 1 shown in these drawings are those described in the above-mentioned Non-Patent Literature. The same applies below.

As can be seen from these drawings, the piezoelectric constant d₃₃ of each of the piezoelectric thin films in Examples 1 to 6 was found to be higher than the maximum piezoelectric constant d₃₃ (14 pC/N) of conventional ScₓGa₁₋ₓN described in Non-Patent Literature 1. That is, it was found that the piezoelectric thin film in which x is within the range of 0.39 or more and 0.54 or less and the length of the c-axis is within the range of 4.94×10⁻¹⁰ m or more and less than 5.2×10⁻¹⁰ m is at least higher than the maximum piezoelectric constant d₃₃ (14 pC/N) of conventional ScₓGa₁₋ₓN, and is also higher than the maximum piezoelectric constant d₃₃ (16.9 pC/N) of ScₓGa₁₋ₓN determined by first-principles calculations.

Further, it was found that the piezoelectric thin film in which x is within the range of 0.45 or more and 0.54 or less and the length of the c-axis is within the range of 4.94× 10⁻¹⁰ m or more and less than 5.05× 10⁻¹⁰ m has a higher piezoelectric constant d₃₃ than the maximum piezoelectric constant d₃₃ (27.6 pC/N) of the scandium-doped aluminum nitride (ScₓAl₁₋ₓN) described in the aforementioned Non-Patent Literature 3.

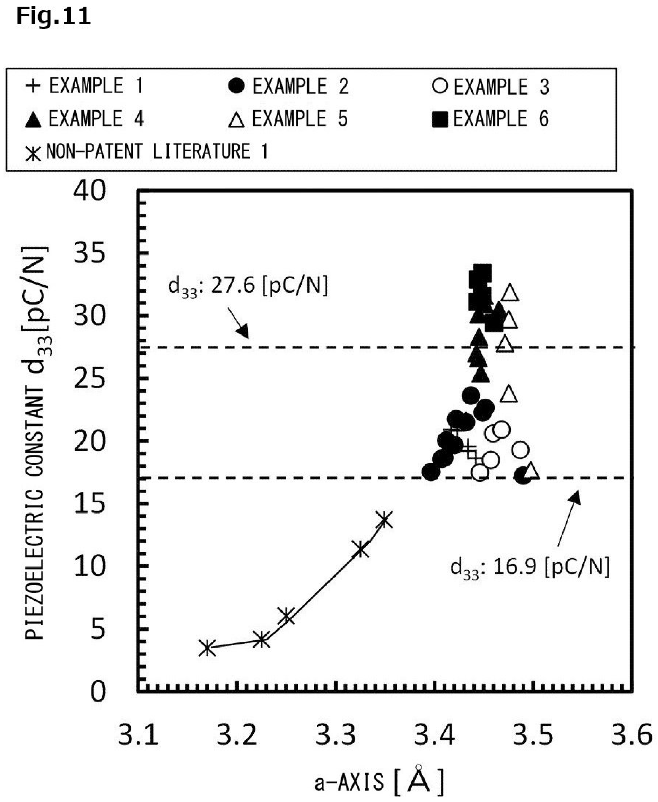

Furthermore, for each of the piezoelectric thin films of Examples 1 to 6, Fig. 11 shows a graph illustrating the relationship between the length of the a-axis and the piezoelectric constant d₃₃. As can be seen from this drawing, it was found that the piezoelectric thin film in which the length of the a-axis is within the range of 3.4×10⁻¹⁰ m or more and 3.5×10⁻¹⁰ m or less is higher than the maximum piezoelectric constant d₃₃ (14 pC/N) of conventional ScₓGa₁₋ₓN, and is also higher than the maximum piezoelectric constant d₃₃ (16.9 pC/N) of ScₓGa₁₋ₓN determined by first-principles calculations.

Moreover, it was found that the piezoelectric thin film in which the length of the a-axis is within the range of 3.44×10⁻¹⁰ m or more and less than 3.48×10⁻¹⁰ m has a higher piezoelectric constant d₃₃ than the maximum piezoelectric constant d₃₃ (27.6 pC/N) of the scandium-doped aluminum nitride (ScₓAl₁₋ₓN) described in the aforementioned Non-Patent Literature 3.

### (Embodiment 2)

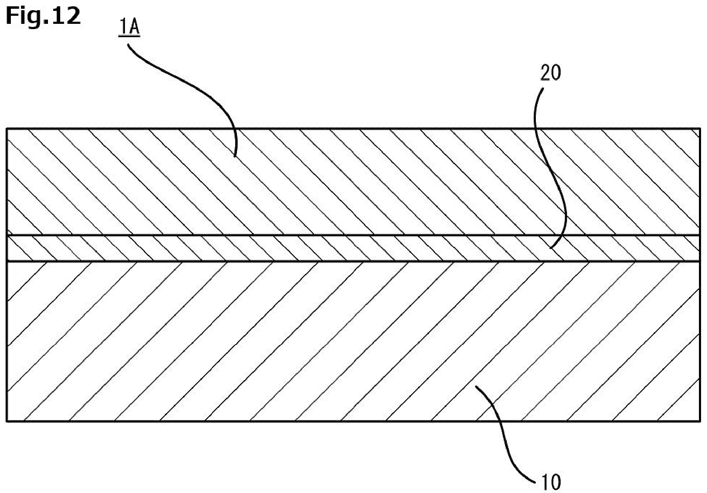

The piezoelectric thin film is formed directly on the substrate in Embodiment 1 described above, but the present invention is not limited to this. For example, as illustrated in Fig. 12, an intermediate layer 20 may be provided between the substrate 10 and a piezoelectric thin film 1A.

The intermediate layer 20 is not particularly limited in thickness, material, and so forth as long as the piezoelectric thin film 1A can be formed on the intermediate layer 20. Examples of the intermediate layer include those made of aluminum nitride (AlN), gallium nitride (GaN), indium nitride (InN), titanium nitride (TiN), scandium nitride (ScN), ytterbium nitride (YbN), molybdenum (Mo), tungsten (W), hafnium (Hf), titanium (Ti), ruthenium (Ru), ruthenium oxide (RuO₂), chromium (Cr), chromium nitride (CrN), platinum (Pt), gold (Au), silver (Ag), copper (Cu), aluminum (Al), tantalum (Ta), iridium (Ir), palladium (Pd), and nickel (Ni) and having the thickness of 1 to 200 nm, and those made of these materials and having the thickness of 50 to 200 nm.

By providing such an intermediate layer 20 on the substrate 10, the crystallinity (degree of crystallinity) of the piezoelectric thin film 1A is improved, thereby being able to form ScₓGa₁₋ₓN having a still higher piezoelectric constant d₃₃ than the piezoelectric thin film of Embodiment 1.

### (Embodiment 3)

The piezoelectric thin film is formed directly on the intermediate layer in Embodiment 2 described above, but the present invention is not limited to this. For example, a diffusion layer containing the material constituting the intermediate layer and the material constituting the piezoelectric thin film may be further provided between the intermediate layer and the piezoelectric thin film. The diffusion layer can be formed, for example, by forming the piezoelectric thin film on the intermediate layer and then applying heat thereto. Even when a diffusion layer is thus provided, the same advantageous effects as those of Embodiment 2 can be obtained.

### (Embodiment 4)

The nitride material according to the present invention is used as a piezoelectric body in Embodiments described above, but the present invention is not limited to this. The nitride material according to the present invention has ferroelectricity and can also be used as a ferroelectric body.

### <Example 7>

Using the following apparatus and sputtering targets, ferroelectric thin films composed of scandium-doped gallium nitride (ScₓGa₁₋ₓN) were deposited directly on conductive silicon substrates (0.02 Ω·cm or less).

Sputtering deposition apparatus (manufactured by ULVAC, Inc.)
Sc sputtering target material (purity: 99.99%)
GaN powder sintered sputtering target material (purity: 99.99%)
Gas: Mixed gas of nitrogen (purity: 99.99995% or higher) and argon gas (purity: 99.9999% or higher) (mixing ratio (nitrogen:argon) 12:88)
Sputtering gas pressure: 0.45 Pa
Substrate heating temperature: 250°C

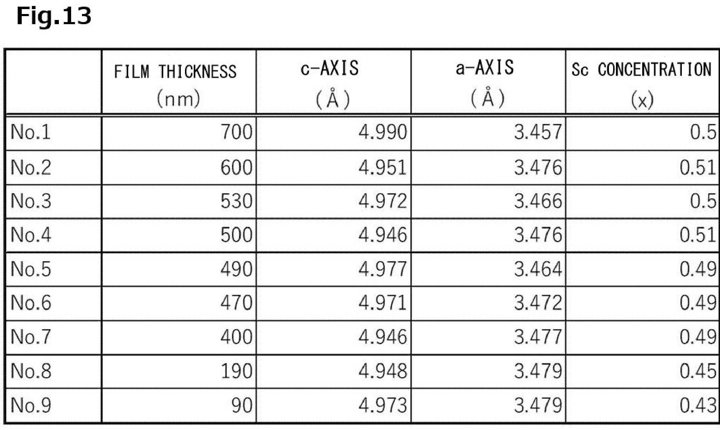

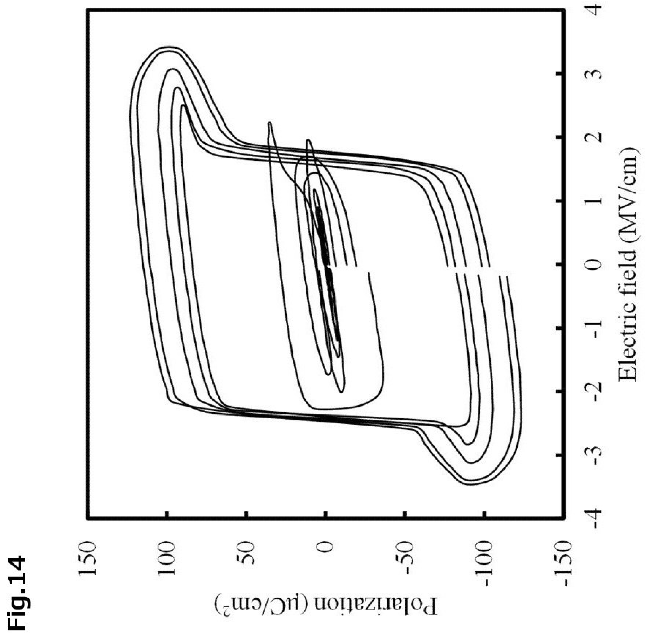

Fig. 13 shows each of the obtained ferroelectric thin films, and for the ferroelectric thin film N0.3 among these, Fig. 14 shows a result obtained by attaching Pt having a 100 µm diameter as an upper electrode by vapor deposition and then measuring the ferroelectricity (electric field-polarization characteristics) using FCE10-S/400-A (manufactured by TOYO Corporation). The ferroelectric thin film N0. 3 exhibits a clear hysteresis loop in this drawing and accordingly, it was found that the ferroelectric thin film N0. 3 has ferroelectricity.

### (Other embodiments)

The piezoelectric thin film using the nitride material according to the present invention is described as an example in Embodiment 1, but the present invention is not limited to this. For example, the nitride material according to the present invention can also be applied to electronic devices such as MEMS devices and ferroelectric memories. Known structures can be adopted for the MEMS devices and electronic devices.

A ferroelectric memory using the nitride material according to the present invention exhibits higher spontaneous polarization and superior memory performance compared to conventional ferroelectric memories.

### Reference Signs List

- 1, 1A: piezoelectric thin film
- 10: substrate
- 20: intermediate layer

## Claims

1. A nitride material expressed by a chemical formula Sc_{ₓ}Ga_{₁₋ₓ}N, wherein
x is within a range of 0.39 or more and 0.54 or less, and
a length of a c-axis in a crystal structure is within a range of 4.94×10⁻¹⁰ m or more and 5.2×10⁻¹⁰ m or less.

2. The nitride material according to claim 1, wherein the x is within a range of 0.45 or more and 0.54 or less.

3. The nitride material according to claim 1, wherein the x is within a range of 0.5 or more and 0.54 or less.

4. The nitride material according to claim 1, wherein the length of the c-axis is within a range of 4.94×10⁻¹⁰ m or more and 5.05×10⁻¹⁰ m or less.

5. The nitride material according to claim 1, wherein a length of an a-axis in the crystal structure is within a range of 3.4×10⁻¹⁰ m or more and 3.5×10⁻¹⁰ m or less.

6. The nitride material according to claim 5, wherein the length of the a-axis is within a range of 3.44× 10⁻¹⁰ m or more and 3.48× 10⁻¹⁰ m or less.

7. The nitride material according to claim 1, wherein a thickness is within a range from 1 nm to 3000 nm.

8. A piezoelectric body composed of the nitride material according to any one of claims 1 to 7.

9. A piezoelectric body wherein the nitride material according to any one of claims 1 to 7 is provided on a substrate, and at least one intermediate layer is provided between the nitride material and the substrate.

10. The piezoelectric body according to claim 9, wherein a diffusion layer containing a material constituting the intermediate layer and a material constituting the piezoelectric body is further provided between the intermediate layer and the piezoelectric body.

11. A MEMS device using the piezoelectric body according to claim 8.

12. A ferroelectric body composed of the nitride material according to any one of claims 1 to 7.

13. An electronic device using the ferroelectric body according to claim 12.

14. A nitride material production method for producing the nitride material according to any one of claims 1 to 7 by using sputtering, wherein
nitrogen is included as a sputtering gas, and
a target composed of scandium and a target composed of gallium nitride, a target composed of scandium and a target composed of an alloy containing scandium and gallium, a target composed of gallium nitride and a target composed of an alloy containing scandium and gallium, or a target composed of an alloy containing scandium and gallium are used as a sputtering target.

15. The nitride material production method according to claim 14, wherein a heating temperature of a substrate, on which the nitride material is to be formed, during film deposition is within a range of 25°C or higher and lower than 400°C.
